# EUROPEAN PATENT APPLICATION

(11) **EP 4 779 823 A1**
(43) Date of publication of application: **22.07.2026**
(21) Application number: 24870391.0
(22) Date of filing: 05.09.2024
(51) Int. Cl.: H01S 5/10, H01S 5/11

(54) **OPTICAL AMPLIFIER, OPTICAL COMPONENT, OPTICAL MODULE, OPTICAL COMMUNICATION NETWORK SYSTEM AND DETECTION DEVICE**

(30) Priority: 26.09.2023 CN 202311271536
(71) Applicant: HUAWEI TECHNOLOGIES CO., LTD., Shenzhen 518129 (CN)
(72) Inventor: LIU, Xia, Shenzhen, Guangdong 518129 (CN); ZHOU, Lei, Shenzhen, Guangdong 518129 (CN)
(74) Representative: Körber, Martin Hans
(86) International application number: PCT/CN2024/117132
(87) International publication number: WO 2025/066845

(57) **Abstract**

This application provides an optical amplifier (10), an optical assembly (30), an optical module, an optical communication network system (1), and a detection apparatus, to resolve a problem that the optical amplifier (10) unidirectionally outputs light, and relates to the field of semiconductor technologies. The optical amplifier (10) includes a waveguide (100) and a photonic crystal (200). The waveguide (100) includes a core region (110) and a cladding region (120) that is disposed at a periphery of the core region (110). The waveguide (100) further includes a light entrance side (101), a first light exit side (102), and a second light exit side (103). The photonic crystal (200) is disposed in the cladding region (120) of the waveguide (100). The core region (110) is located between the light entrance side (101) and the first light exit side (102), and the photonic crystal (200) is located between the second light exit side (103) and the core region (110). The photonic crystal (200) is configured to: receive incident light from the light entrance side (101), and output first emergent light and second emergent light. The first emergent light is emergent from the first light exit side, and the second emergent light is emergent from the second light exit side.

## Description

This application claims priority to Chinese Patent Application No. 202311271536.2, filed with the China National Intellectual Property Administration on September 26, 2023 and entitled "OPTICAL AMPLIFIER, OPTICAL ASSEMBLY, OPTICAL MODULE, OPTICAL COMMUNICATION NETWORK SYSTEM, AND DETECTION APPARATUS", which is incorporated herein by reference in its entirety.

### TECHNICAL FIELD

This application relates to the field of semiconductor technologies, and in particular, to an optical amplifier, an optical assembly, an optical module, an optical communication network system, and a detection apparatus.

### BACKGROUND

Optical amplifiers are widely used in the fields of optical communication and optical sensing. For example, an optical amplifier may be used for applications such as optical signal amplification, signal regeneration, wavelength conversion, and pulse reshaping. With an advantage of easy integration, the optical amplifier can be monolithically integrated with a laser, a modulator, and the like, and therefore occupies an important position in the field of photonic chips.

However, a conventional optical amplifier unidirectionally outputs light, and a detection end side cannot be provided. As a result, an application field of the optical amplifier is limited, and an operating status of the optical amplifier cannot be determined.

### SUMMARY

Embodiments of this application provide an optical amplifier, an optical assembly, an optical module, an optical communication network system, and a detection apparatus, to resolve a problem that an optical amplifier unidirectionally outputs light.

To achieve the foregoing objective, this application uses the following technical solutions.

According to a first aspect of embodiments of this application, an optical amplifier is provided, including a waveguide and a photonic crystal. The waveguide includes a core region and a cladding region that is disposed at a periphery of the core region. The waveguide further includes a light entrance side, a first light exit side, and a second light exit side. The photonic crystal is disposed in the cladding region. The core region is located between the light entrance side and the first light exit side, and the photonic crystal is located between the second light exit side and the core region. The photonic crystal is configured to: receive incident light from the light entrance side, and output first emergent light and second emergent light. The first emergent light is emergent from the first light exit side, and the second emergent light is emergent from the second light exit side.

According to the optical amplifier provided in this embodiment of this application, the photonic crystal is disposed in the cladding region of the waveguide. After the incident light passes through the photonic crystal, the photonic crystal transmits the first emergent light and the second emergent light. In other words, the optical amplifier provided in this embodiment of this application can bidirectionally output light, and light output ratios of the first emergent light and the second emergent light may be adjusted. In addition, according to the optical amplifier provided in this embodiment of this application, an operating status of the optical amplifier can be determined by detecting the emergent light from either of the light exit sides.

In a possible implementation, the first emergent light is transmitted from the photonic crystal, and the second emergent light is reflected from the photonic crystal. In this way, the first emergent light and the second emergent light that may be output after the incident light passes through the photonic crystal may be emergent from two directions respectively.

In a possible implementation, the photonic crystal is located on a surface of the cladding region. This can further reduce a divergence angle of the second emergent light.

In a possible implementation, the photonic crystal is located on a side of the core region in a thickness direction of the waveguide. In this way, the first emergent light and the second emergent light are output perpendicularly, which can improve flexibility of packaging of the optical amplifier.

In a possible implementation, in a first direction, an edge of the photonic crystal does not extend beyond an edge of the core region, the first direction is perpendicular to a direction in which the waveguide extends, and the first direction is further perpendicular to the thickness direction of the waveguide. This can improve intensity of the first emergent light and the second emergent light.

In a possible implementation, a size of the photonic crystal in the first direction is the same as a size of the core region in the first direction, the first direction is perpendicular to the direction in which the waveguide extends, and the first direction is further perpendicular to the thickness direction of the waveguide. This can further improve the intensity of the first emergent light and the second emergent light.

In a possible implementation, there is a spacing between the photonic crystal and the core region. This can prevent a material of the photonic crystal from diffusing into the core region.

In a possible implementation, the optical amplifier further includes a buffer layer, and the buffer layer is located between the core region and the cladding region. This can prevent the material of the photonic crystal from diffusing into the core region.

In a possible implementation, the photonic crystal includes a third light exit side, the second emergent light is emergent from the third light exit side, and the third light exit side includes a plurality of circular light exit holes. This can reduce the divergence angle of the second emergent light.

In a possible implementation, the waveguide includes any one of a ridge waveguide, a rectangular waveguide, or a buried waveguide. In this way, the waveguide can be implemented in a plurality of manners.

In a possible implementation, the waveguide includes a ridge waveguide. The ridge waveguide includes a plate part and a ridge part that is disposed on the plate part. The core region includes a portion that is of the plate part and that is covered by the ridge part, the cladding region includes the ridge part and a portion of the plate part excluding the core region, and the photonic crystal is disposed in the ridge part. In this way, the photonic crystal can be disposed in the ridge waveguide.

In a possible implementation, the photonic crystal includes a two-dimensional photonic crystal or a three-dimensional photonic crystal. In this way, the photonic crystal is implemented in a plurality of manners.

According to a second aspect of embodiments of this application, an optical assembly is provided, including the optical amplifier according to any implementation of the first aspect and a light source. The light source provides an optical signal for the optical amplifier.

The optical assembly provided in the second aspect of embodiments of this application includes the optical amplifier according to any implementation of the first aspect. Therefore, beneficial effects of the optical assembly are the same as the beneficial effects of the optical amplifier. Details are not described herein again.

According to a third aspect of embodiments of this application, an optical module is provided, including a receiving optical sub-assembly and a transmitting optical sub-assembly. The receiving optical sub-assembly receives an optical signal transmitted by the sending optical sub-assembly. The receiving optical sub-assembly includes the optical assembly according to the second aspect.

The optical module provided in the third aspect of embodiments of this application includes the optical assembly according to the second aspect. Therefore, beneficial effects of the optical module are the same as the beneficial effects of the optical assembly. Details are not described herein again.

According to a fourth aspect of embodiments of this application, an optical module is provided, including a receiving optical sub-assembly and a transmitting optical sub-assembly. The receiving optical sub-assembly receives an optical signal transmitted by the sending optical sub-assembly. The receiving optical sub-assembly includes the optical assembly in the second aspect.

The optical module provided in the fourth aspect of embodiments of this application includes the optical assembly according to the second aspect. Therefore, beneficial effects of the optical module are the same as the beneficial effects of the optical assembly. Details are not described herein again.

According to a fifth aspect of embodiments of this application, an optical communication network system is provided, including at least two optical communication devices and an optical fiber. The optical communication devices are connected through the optical fiber, and the optical communication devices include the optical module according to the third aspect or the fourth aspect.

The optical communication network system provided in the fifth aspect of embodiments of this application includes the optical module according to the third aspect or the fourth aspect. Therefore, beneficial effects of the optical communication network system are the same as the beneficial effects of the optical module. Details are not described herein again.

In a possible implementation, the optical communication network system includes a passive optical network system. The at least two optical communication devices include an optical line terminal, an optical network unit, and an optical network terminal. The optical network unit is connected to the optical line terminal and the optical network terminal.

According to a sixth aspect of embodiments of this application, a detection apparatus is provided, including the optical amplifier according to the first aspect and a receiver. The receiver is configured to receive an optical signal output by the optical amplifier.

The detection apparatus provided in the sixth aspect of embodiments of this application includes the optical amplifier according to any implementation of the first aspect. Therefore, beneficial effects of the detection apparatus are the same as the beneficial effects of the optical amplifier. Details are not described herein again.

### BRIEF DESCRIPTION OF DRAWINGS

FIG. 1 is a diagram of a structure of an optical communication network system according to an embodiment of this application;
FIG. 2 is a diagram of a structure of an optical amplifier according to an embodiment of this application;
FIG. 3 is a diagram of a structure of an optical amplifier according to an embodiment of this application;
FIG. 4 is a diagram of a structure of an optical amplifier according to an embodiment of this application;
FIG. 5 is a diagram of another structure of an optical amplifier according to an embodiment of this application;
FIG. 6 is a diagram of a structure of another optical amplifier according to an embodiment of this application;
FIG. 7A is a diagram of another structure of an optical amplifier according to an embodiment of this application;
FIG. 7B is a diagram of another structure of an optical amplifier according to an embodiment of this application;
FIG. 7C is a diagram of another structure of an optical amplifier according to an embodiment of this application;
FIG. 8A is a diagram of a structure of a photonic crystal according to an embodiment of this application;
FIG. 8B is a diagram of another structure of a photonic crystal according to an embodiment of this application;
FIG. 8C is a diagram of another structure of a photonic crystal according to an embodiment of this application;
FIG. 9 is a diagram of another structure of an optical amplifier according to an embodiment of this application;
FIG. 10A is a diagram of another structure of an optical amplifier according to an embodiment of this application;
FIG. 10B is a diagram of another structure of an optical amplifier according to an embodiment of this application;
FIG. 10C is a diagram of another structure of an optical amplifier according to an embodiment of this application;
FIG. 11 is a diagram of another structure of an optical amplifier according to an embodiment of this application;
FIG. 12A is a diagram of a principle of an electronic device according to an embodiment of this application;
FIG. 12B is a diagram of a structure of an electronic device according to an embodiment of this application;
FIG. 13A is a diagram of a structure of an optical assembly according to an embodiment of this application;
FIG. 13B is a diagram of another structure of an optical assembly according to an embodiment of this application;
FIG. 13C is a diagram of another structure of an optical assembly according to an embodiment of this application;
FIG. 14A is a diagram of another structure of an optical assembly according to an embodiment of this application;
FIG. 14B is a diagram of a structure of an on-chip optical frequency comb according to an embodiment of this application; and
FIG. 15 is a diagram of a principle of gas detection according to an embodiment of this application.

### Reference numerals:

1: optical communication network system; 2: optical line terminal; 3: optical distribution network; 4: optical network unit; 5: optical network terminal; 10: optical amplifier; 11: first transmission fiber; 12: second transmission fiber; 21: first optical element; 22: second optical element; 100: waveguide; 200: photonic crystal; 110: core region; 120: cladding region; 121: lower cladding region; 122: upper cladding region; 101: light entrance side; 102: first light exit side; 103: second light exit side; 20: electronic device; 30: optical assembly; 310: substrate; 320: laser; 330: modulator; 340: microring.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "second", "first", and the like below are merely intended for ease of description, and shall not be understood as an indication or implication of relative importance or an implicit indication of a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts. They are used for description and clarification of relative positions, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact, or may be indirect contact through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

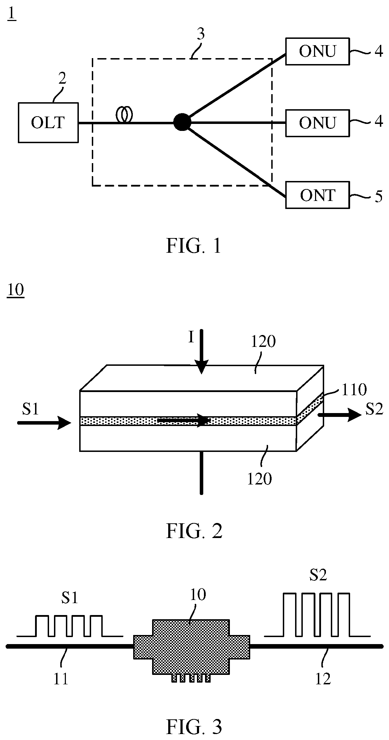

An embodiment of this application provides an optical communication network system. As shown in FIG. 1, the optical communication network system 1 mainly includes at least two optical communication devices and an optical fiber connecting the optical communication devices.

An optical communication network system has become a mainstream communication network system. For example, in the optical communication network system 1, an access mode of an access network (access network, AN) is fiber to the x (FTTx), and the access network is also referred to as an optical access network (optical access network, OAN). Optical fiber access modes of the optical access network include fiber to the cabinet (fiber to the cabinet, FTTCab), fiber to the curb (fiber to the curb, FTTC), fiber to the building (fiber to the building, FTTB), fiber to the home (fiber to the home, FTTH), and the like.

In some embodiments, the optical communication network system 1 is integrated in an electronic device. The electronic device may include, for example, a server, a switch, an optical fiber network adapter, and an optical fiber transceiver. The optical communication network system 1 may be integrated in a same electronic device, or may be separately integrated in different electronic devices. This is not limited in embodiments of this application, and may be appropriately set based on an actual situation.

For example, when a passive optical network (passive optical network, PON) is used as the optical communication network system, the optical communication device may include any one of an optical line terminal (optical line terminal, OLT), an optical network unit (optical network unit, ONU), or an optical network terminal (optical network terminal, ONT).

Specific types and structures of the optical communication network system 1 and the optical communication device are not limited in embodiments of this application, and may be appropriately set based on an actual situation.

An example in which the optical communication network system is a passive optical fiber network is used for illustration. As shown in FIG. 1, the PON includes an optical line terminal 2, an optical distribution network (optical distribution network, ODN) 3, an optical network unit 4, and an optical network terminal 5.

The OLT 2 is disposed at a central control station, and the ODN 3 is disposed on a user side. The OND 3 is used to connect the OLT 2 and the ONU 4. Optical components in the OLT 2 and the ONU 4 are configured to perform optical-to-electrical conversion and transmission on a network signal.

In some embodiments, as shown in FIG. 1, the ONT 5 and the ONU 4 are disposed at different locations on the user side, and implement similar functions.

The ODN 3 includes an optical splitter (optical splitter, SPL) and an optical fiber. A function of the optical splitter is to split one channel of light into two channels of light based on an optical splitting ratio, to transmit the two channels of light to the ONU 4 and the ONT 5 respectively. Generally, a larger quantity of cascaded optical splitters in the ODN 3 indicates a larger quantity of light splitting times, and a larger quantity of channels of light that can be split.

For example, the OLT 2 is disposed at the central control station, and the ODN 3 is disposed on the user side. The ODN 3 is used to connect the OLT 2 and the ONU 4. Optical modules in the OLT 2 and the ONU 4 are configured to perform optical-to-electrical conversion and transmission on a network signal. The ONT 5 and the ONU 4 are disposed at different locations on the user side, and implement similar functions.

The optical module may be integrated in the ONU 4 or the ONT 5, or the optical module may be integrated in the OLT 2.

For example, the optical module may include a small form-factor pluggable transceiver (SFP) optical module, an SFP+ optical module, or an XFP optical module. This is not limited in embodiments of this application.

In some embodiments, the optical module includes a transmitting optical sub-assembly (transmitting optical sub-assembly, TOSA) and a receiving optical sub-assembly (receiving optical sub-assembly, ROSA). Both the transmitting optical sub-assembly and the receiving optical sub-assembly are electrically connected to a printed circuit board.

For example, a bi-directional optical sub-assembly (bi-directional optical sub-assembly, BOSA) formed by integrating the transmitting optical sub-assembly and the receiving optical sub-assembly may be considered as an optical assembly, or may be considered as the optical module.

For example, the transmitting optical sub-assembly includes an electrical-to-optical conversion chip and a photodiode (for example, a monitor photodiode (MD)). The electrical-to-optical conversion chip and the monitor photodiode are packaged together to form the transmitting optical sub-assembly. The monitor photodiode is configured to monitor power of light output by a laser.

The electrical-to-optical conversion chip receives an electrical signal that is transmitted by the printed circuit board (printed circuit board, PCB) and that carries sending information, converts the electrical signal into an optical signal, and outputs the optical signal through the optical component.

For example, the receiving optical sub-assembly includes an optical-to-electrical conversion chip and an amplifier. The optical-to-electrical conversion chip and the amplifier are packaged together to form the receiving optical sub-assembly. For example, the optical-to-electrical conversion chip may be a chip including a photodiode (photodiode, PD), a PIN diode (PIN diode), or an avalanche photodiode (avalanche photodiode, APD). The optical-to-electrical conversion chip converts a received optical signal into an electrical signal, and then transmits the electrical signal to the amplifier. The amplifier amplifies the electrical signal, and transmits an amplified electrical signal to the PCB.

Based on this, an embodiment of this application further illustrates an optical amplifier. The optical amplifier may be used in any one of the optical communication network system, the optical module, or the optical assembly.

For example, the optical amplifier is used in the transmitting optical sub-assembly. In this case, the optical amplifier is configured to: amplify an optical signal transmitted by a light source, and output the optical signal through the optical component.

Alternatively, for example, the optical amplifier is used in the receiving optical sub-assembly. In this case, the optical amplifier is configured to: amplify a received optical signal, and then convert the optical signal into an electrical signal for processing.

In some embodiments, the optical assembly further includes the optical amplifier. The optical amplifier amplifies an optical signal.

The optical amplifier, for example, a semiconductor optical amplifier (semiconductor optical amplifier, SOA), is widely used in the fields of optical communication and optical sensing. For example, the optical amplifier may be used for applications such as optical signal amplification, optical signal regeneration, wavelength conversion, and pulse reshaping. For example, the optical amplifier may be used in the foregoing electronic device or a wearable device.

For example, as a semiconductor chip with an advantage of easy integration, the semiconductor optical amplifier may be monolithically integrated with a laser, a modulator, and the like to prepare a complex chip, and therefore occupies an important position in the field of photonic chips.

An embodiment of this application illustrates an optical amplifier. As shown in FIG. 2, an optical amplifier 10 includes a core region 110 and a cladding region 120. The cladding region 120 is located at a periphery of the core region 110.

The cladding region 120 may surround all of the periphery of the core region 110. Alternatively, the cladding region 120 may surround a part of the periphery of the core region 110. This is not limited in embodiments of this application.

For example, as shown in FIG. 2, the cladding region 120 is located on two opposite sides of the core region 110. A first optical signal S1 is input from a side of the core region 110, and the first optical signal S1 is transmitted in the core region 110, while a current I is applied to a side that is of the cladding region 120 and that is away from the core region 110. In this case, stimulated emission occurs on the first optical signal S1 in the core region 110, resulting in optical signal amplification, and a second optical signal S2 is output from the other side of the core region 110. The second optical signal S2 is the first optical signal S1 obtained through amplification by the optical amplifier 10.

As shown in FIG. 3, the first optical signal S1 is input into the optical amplifier 10 through a first transmission fiber 11, and after the first optical signal S1 is amplified, the second optical signal S2 is output through a second transmission fiber 12. The second optical signal S2 is the amplified first optical signal S1.

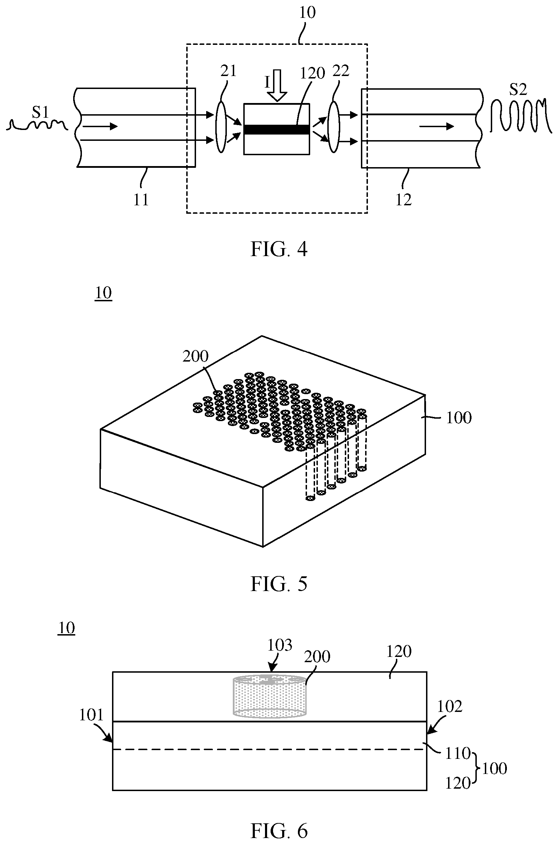

For example, as shown in FIG. 4, an optical element is further disposed on each of a light entrance side and a light exit side of the optical amplifier 10. As shown in FIG. 4, the first optical signal S1 is transmitted to a first optical element 21 through the first transmission fiber 11, and the first optical element 21 converges the first optical signal S1 and then transmits the first optical signal S1 to the optical amplifier 10. Then, the optical amplifier 10 amplifies the first optical signal S1 and outputs the second optical signal S2. The second optical signal S2 is diverged by a second optical element 22 and then transmitted to the second transmission fiber 12 for output.

As shown in FIG. 2, the optical amplifier 10 outputs light in a direction in which the core region 110 extends. In other words, the optical amplifier 10 has only one light output direction. That is, the optical amplifier unidirectionally outputs light.

An embodiment of this application further illustrates an optical amplifier. As shown in FIG. 5, a large quantity of air holes of a photonic crystal 200 are etched on two sides of a waveguide 100, and an optical transmission channel is reserved in the middle of the waveguide 100 to form an optical transmission channel of a structure similar to a strip waveguide.

However, the optical amplifier 10 has a complex structure and incurs high preparation costs.

In addition, because the optical amplifiers 10 all unidirectionally output light, a detection end cannot be provided. As a result, an application field of the optical amplifier 10 is limited, and an operating status of the optical amplifier 10 cannot be determined. In addition, light output by the optical amplifier 10 has a large divergence angle (10° to 25°). Therefore, a beam shaping and coupling element (the second optical coupling element) needs to be additionally disposed on the light exit side of the optical amplifier 10, so that the optical signal that is amplified and then output by the optical amplifier can be coupled into the optical fiber.

Based on this, to resolve a problem that the optical amplifier unidirectionally outputs light, embodiments of this application provide an optical amplifier. As shown in FIG. 6, the optical amplifier 10 includes a waveguide 100 and a photonic crystal 200. The waveguide 100 includes a core region 110 and a cladding region 120 that is disposed at a periphery of the core region 110. The waveguide 100 further includes a light entrance side 101, a first light exit side 102, and a second light exit side 103. The photonic crystal 200 is disposed in the cladding region 120 of the waveguide 100. The core region 110 is located between the light entrance side 101 and the first light exit side 102, and the photonic crystal 200 is located between the second light exit side 103 and the core region 110.

The photonic crystal 200 is configured to: receive incident light from the light entrance side 101, and output first emergent light and second emergent light. The first emergent light is emergent from the first light exit side 102, and the second emergent light is emergent from the second light exit side 103.

In other words, in the direction in which the core region 110 extends, the light entrance side 101 and the first light exit side 102 are respectively located on two sides of the core region 110.

In some embodiments, the waveguide 100 may include any one of a ridge waveguide, a rectangular waveguide, or a buried waveguide.

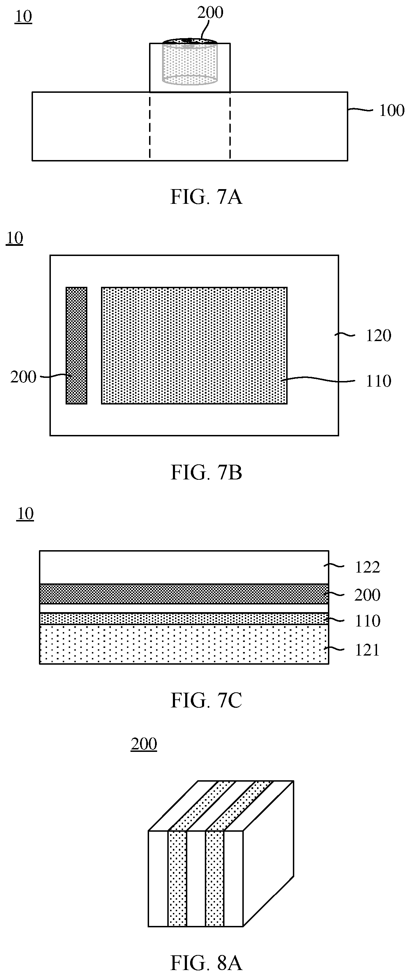

For example, as shown in FIG. 7A, the waveguide 100 is a ridge waveguide. The ridge waveguide includes a plate part and a ridge part. The ridge part is disposed on the plate part.

In other words, a protruding portion of the ridge waveguide is the ridge part, and a portion excluding the ridge part in the ridge waveguide is the plate part.

For ease of illustration, a direction from the ridge part toward the plate part is referred to as a thickness direction z of the waveguide. In other words, a direction from the plate part toward the ridge part is also referred to as the thickness direction z of the waveguide.

For the ridge waveguide, as shown in FIG. 7A, the core region 110 includes a portion that is of the plate part and that is covered by the ridge part, and the cladding region 120 includes the ridge part and a portion of the plate part excluding the core region 110.

In other words, the portion that is of the plate part of the ridge waveguide and that is covered by the ridge part is the core region 110 of the ridge waveguide; and the portion that is of the plate part of the ridge waveguide and that is not covered by the ridge part, and the ridge part of the ridge waveguide are the cladding region 120 of the ridge waveguide.

The photonic crystal 200 is disposed in the cladding region 120 of the ridge waveguide. For example, the photonic crystal 200 may be disposed in the ridge part of the ridge waveguide. Alternatively, for example, the photonic crystal 200 may be disposed in the plate part of the ridge waveguide. It is explained herein that the photonic crystal 200 is disposed on two sides of the plate part, that is, in the cladding region 120 in the plate part.

Alternatively, for example, as shown in FIG. 7B, the waveguide 100 is a rectangular waveguide.

As shown in FIG. 7B, the rectangular waveguide includes the core region 110 and the cladding region 120 that surrounds the periphery of the core region 110.

For example, the photonic crystal 200 may be disposed in the cladding region 120 of the rectangular waveguide. A location of the photonic crystal 200 is not limited in embodiments of this application, and may be appropriately set based on an actual situation.

Alternatively, for example, as shown in FIG. 7C, the waveguide 100 is a buried waveguide.

As shown in FIG. 7C, the buried waveguide includes a lower cladding region 121, the core region 110, and an upper cladding region 122 that are sequentially stacked.

The photonic crystal 200 may be disposed in the upper cladding region 122 of the buried waveguide. Alternatively, the photonic crystal 200 may be disposed in the lower cladding region 121 of the buried waveguide. This is not limited in embodiments of this application, and may be appropriately set based on an actual situation.

It is explained herein that a type of the waveguide 100 included in the optical amplifier 10 is not limited in embodiments of this application, and may be appropriately set based on an actual situation. For ease of illustration, the following uses an example in which the waveguide 100 is a ridge waveguide.

For the photonic crystal 200, still refer to FIG. 6. The photonic crystal 200 is disposed in the cladding region 120 of the waveguide 100. In other words, the photonic crystal 200 is disposed in the cladding region 120 of the waveguide 100 described above.

In this embodiment of this application, the photonic crystal 200 is configured to: receive incident light, and output first emergent light and second emergent light.

The incident light is incident onto the photonic crystal 200 from the light entrance side 101 of the waveguide 100. Then, the first emergent light output by the photonic crystal 200 is emergent from the first light exit side 102 of the waveguide 100, and the second emergent light output by the photonic crystal 200 is emergent from the second light exit side 103 of the waveguide 100.

For example, the first emergent light is transmitted from the photonic crystal 200, and the second emergent light is reflected from the photonic crystal 200.

In other words, the photonic crystal 200 is disposed in the waveguide 100. It may be considered that a semi-transparent and semi-reflective mirror is disposed in the waveguide 100, and the photonic crystal 200 may control a propagation direction of the incident light.

For ease of understanding, the following first briefly describes the photonic crystal. The photonic crystal is a periodic dielectric structure with a photonic band gap (photonic band gap, PBG) characteristic. A photonic band gap is a frequency range in which waves cannot be propagated in the periodic structure. In other words, the structure itself has a "forbidden band".

To be specific, in a dielectric material whose dielectric coefficients are periodically arranged, after electromagnetic waves are scattered by the dielectric material, strength of the electromagnetic waves in some bands exponentially attenuates due to destructive interference, and the electromagnetic waves cannot be transmitted in the dielectric material. This is equivalent to forming an energy gap in a frequency spectrum, so that a dispersion relation also has a photonic band structure (photonic band structure). The dielectric material with the photonic energy band structure is referred to as the photonic crystal, or may be referred to as a photonic energy gap system or a PBG photonic crystal structure.

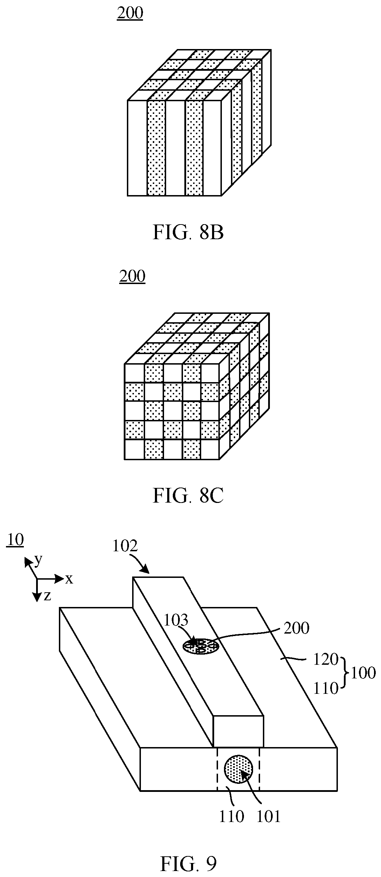

For example, as shown in FIG. 8A to FIG. 8C, the periodic structure of the photonic crystal may include a one-dimensional photonic crystal, a two-dimensional photonic crystal, and a three-dimensional photonic crystal in a spatially periodic arrangement manner.

It is explained herein that the photonic crystal in the optical amplifier provided in this embodiment of this application includes either of the two-dimensional photonic crystal or the three-dimensional photonic crystal.

In some embodiments, as shown in FIG. 9, the photonic crystal 200 is located on a side of 110 in the thickness direction z of the waveguide 100.

In other words, for the ridge waveguide, the photonic crystal 200 is disposed in the ridge part of the ridge waveguide.

For ease of illustration, as shown in FIG. 9, the thickness direction z of the waveguide 100 is referred to as a third direction z, and the direction in which the waveguide 100 extends is referred to as a second direction y. A direction perpendicular to both the thickness direction z of the waveguide 100 and the direction y in which the waveguide 100 extends is referred to as a first direction x. In other words, any two of the first direction x, the second direction y, and the third direction z are perpendicular to each other.

Still with reference to FIG. 9, in the direction y in which the waveguide 100 extends, namely, the second direction y, a location of the photonic crystal 200 is not limited in embodiments of this application. For example, the photonic crystal 200 may be disposed at a middle position between the light entrance side 101 and the first light exit side 102. Alternatively, for example, the photonic crystal 200 may be disposed at a position close to the light entrance side 101. Alternatively, for example, the photonic crystal 200 may be disposed at a position close to the first light exit side 102.

As shown in FIG. 9, in the first direction x, an edge of the photonic crystal 200 does not extend beyond an edge of the core region 110.

In other words, in the third direction z, a projection of the photonic crystal 200 is within a projection of the core region 110.

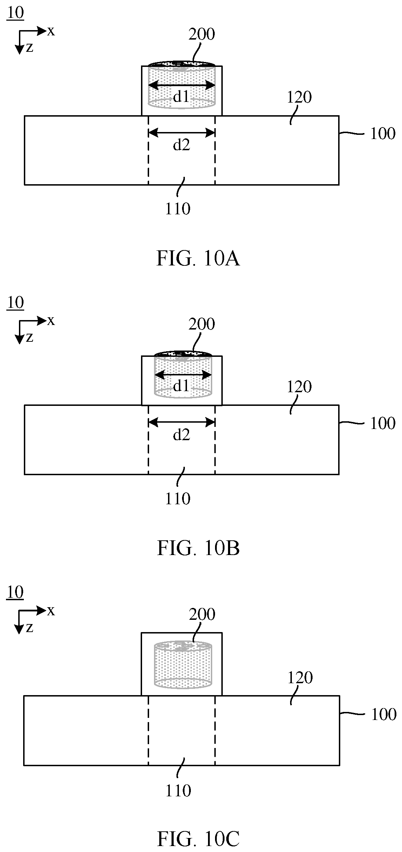

For example, as shown in FIG. 10A, a size d1 of the photonic crystal 200 in the first direction x is the same as a size d2 of the core region 110 in the first direction x.

In other words, in the first direction x, the edge of the photonic crystal 200 coincides with the edge of the core region 110; or
in the third direction z, the projection of the photonic crystal 200 coincides with the projection of the core region 110.

This can improve a light output rate of the optical amplifier 10.

Alternatively, for example, as shown in FIG. 10B, a size d1 of the photonic crystal 200 in the first direction x is less than a size d2 of the core region 110 in the first direction x.

For example, as shown in FIG. 10B, the photonic crystal 200 may be located on a surface of the cladding region 120.

In other words, the photonic crystal 200 is exposed on a surface that is of the cladding region 120 and that is away from the core region 110.

It is explained herein that the surface that is of the cladding region 120 and on which the photonic crystal 200 is exposed is a surface that is of the second light exit side 103 of the waveguide 100.

Alternatively, for example, as shown in FIG. 10C, the photonic crystal 200 may be located in the cladding region 120.

In other words, the cladding region 120 surrounds a periphery of the photonic crystal 200.

In some embodiments, as shown in FIG. 10C, there is a spacing between the photonic crystal 200 and the core region 110.

In this way, the spacing between the photonic crystal 200 and the core region 110 can prevent a material of the photonic crystal 200 from diffusing into the core region 110, thereby avoiding affecting light output of the optical amplifier 10.

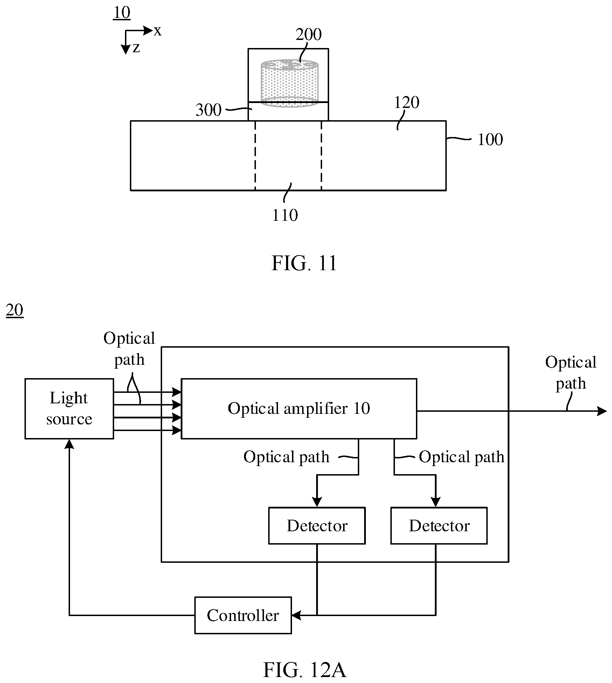

As shown in FIG. 11, the optical amplifier 10 further includes a buffer layer 300. The buffer layer 300 is located between the core region 110 and the cladding region 120.

For example, the buffer layer 300 may be a material film layer of the waveguide 100.

In this way, the buffer layer 300 is disposed between the core region 110 and the cladding region 120, which can prevent the material of the photonic crystal 200 from diffusing into the core region 110, thereby avoiding affecting light output of the optical amplifier 10.

In some embodiments, the photonic crystal 200 further includes a third light exit side. The second emergent light is emergent from the third light exit side.

The third light exit side includes a plurality of circular light exit holes.

In this way, the circular light exit holes can reduce a divergence angle of emergent light, to implement direct coupling between the emergent light and the optical receiving element, and no corresponding optical coupling element needs to be separately disposed. For example, the divergence angle of the emergent light is less than 1°. In other words, a divergence angle of the second emergent light of the optical amplifier 10 is less than 1°. In addition, a corresponding photonic crystal 200 may be designed to filter out noise of the optical amplifier 10, for example, amplifier spontaneous emission noise (amplifier spontaneous emission noise, ASE), to improve quality of an optical signal of the output light.

In some embodiments, the optical amplifier 10 further includes a high-transmittance anti-reflective (anti-reflective, AR) film.

For example, the high-transmittance anti-reflective film is disposed on the light entrance side 101 of the waveguide 100.

This can increase a transmittance of light.

According to the optical amplifier 10 provided in this embodiment of this application, after incident light is incident from the light entrance side 101, a current is injected into the optical amplifier 10. This enables population inversion of the incident light, thereby achieving amplification of the incident light. Then, an amplified optical signal passes through the photonic crystal 200, and the photonic crystal 200 outputs the first emergent light and the second emergent light.

In addition, according to the optical amplifier 10 in this embodiment of this application, the photonic crystal 200 may be changed to adjust light output ratios of the first emergent light and the second emergent light, and after an optical parameter of either the first emergent light or the second emergent light is detected, an optical parameter of the other emergent light may be inferred. For example, the optical parameter of the emergent light may include a light intensity of the emergent light.

For example, a detection apparatus may be disposed on the first light exit side 102 or the second light exit side 103, to detect the optical parameter of the emergent light and further determine an operating status of the optical amplifier 10.

According to the optical amplifier 10 provided in this embodiment of this application, the photonic crystal 200 is disposed in the cladding region 120 of the waveguide 100. After incident light passes through the photonic crystal 200, the photonic crystal 200 transmits the first emergent light and the second emergent light. In other words, the optical amplifier 10 provided in this embodiment of this application can bidirectionally output light, and a corresponding photonic crystal 200 may be designed to adjust the light output ratios of the first emergent light and the second emergent light. In addition, according to the optical amplifier 10 provided in this embodiment of this application, the operating status of the optical amplifier 10 can be determined by detecting the emergent light on either of the light exit sides.

Based on this, an embodiment of this application further provides an electronic device. The electronic device may be, for example, an intelligent wearable product (for example, a smartwatch or a smart band). As shown in FIG. 12A, the electronic device 20 includes a light source and the optical amplifier 10. In other words, the optical amplifier 10 is integrated in the electronic device 20.

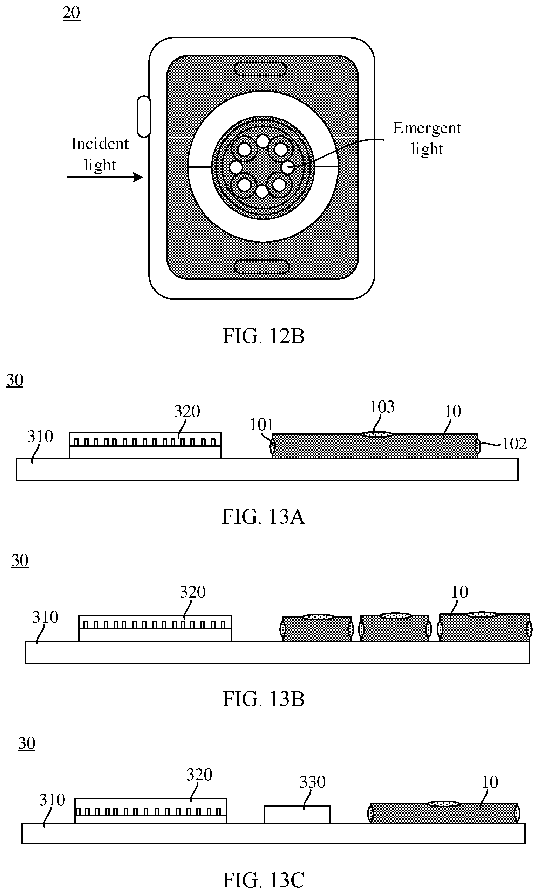

For example, as shown in FIG. 12B, incident light of the optical amplifier 10 is emergent from a side of the electronic device 20, and light emergent from the second light exit side of the optical amplifier 10 can be used for performing optical sensing on an obstruction (for example, human skin), to implement a detection function. The optical amplifier 10 can amplify an optical signal to improve penetration of the emergent light. In addition, the photonic crystal 200 in the optical amplifier 10 can be used to change an output direction of the emergent light, and filter out ASE noise of the emergent light, thereby improving fidelity of the output optical signal.

In some other embodiments, an embodiment of this application further provides an optical transmitting system on chip. The optical transmitting system on chip may be considered as a transmitting optical sub-assembly. As shown in FIG. 13A, the optical assembly 30 includes a substrate 310, a laser 320 disposed on the substrate 310, and an optical amplifier 10 disposed on the substrate 310. The laser 320 and the optical amplifier 10 are disposed on a same side of the substrate 310.

A material of the substrate 310 is not limited in embodiments of this application. The material of the substrate 310 may include, for example, any one or a combination of gallium arsenide (GaAs), indium phosphate (InP), or silicon-on-insulator (silicon-on-insulator, SOI).

For example, the laser 320 may include either of a distributed feedback Bragg semiconductor laser (distributed feedback Bragg laser diode, DFB) or a distributed Bragg reflector semiconductor laser (distributed Bragg reflector laser diode, DBR). This is not limited in embodiments of this application.

As shown in FIG. 13A, the laser 320 is disposed on the light entrance side of the optical amplifier 10. In other words, the optical amplifier 10 is disposed on the light exit side of the laser 320. The laser 320 may be used as a light source to provide an optical signal for the optical amplifier 10.

For example, as shown in FIG. 13A, the optical assembly 30 includes one optical amplifier 10.

Alternatively, for example, as shown in FIG. 13B, the optical assembly 30 includes a plurality of optical amplifiers 10. The plurality of optical amplifiers 10 may be sequentially disposed on the substrate 310, or may be stacked on the substrate 310. A quantity of the optical assemblies 30 and a stacking manner of the optical assemblies 30 are not limited in this embodiment of this application, and may be appropriately set based on an actual situation.

In some embodiments, as shown in FIG. 13C, the optical assembly 30 further includes a modulator 330. The modulator 330 is disposed on the substrate 310, and is located between the laser 320 and the optical amplifier 10.

For example, the modulator 330 may include an electro-absorption modulator (electro-absorption modulator, EAM).

As shown in FIG. 13C, the laser 320 is used as a light source to provide an optical signal. As a signal modulator, the modulator 330 modulates the optical signal output by the laser 320, and transmits a modulated optical signal to the optical amplifier 10. The optical amplifier 10 amplifies a received optical signal, and outputs emergent light in two directions: first emergent light in a direction in which the substrate 310 extends and second emergent light perpendicular to the substrate 310. One of the emergent light may be used as a monitoring window to detect an operating status of the optical assembly 30.

For example, the optical assembly 30 may be integrated in the electronic device 20 (for example, an intelligent wearable device), the first emergent light is used as the monitoring window, and the second emergent light is used to detect a signal.

The optical assembly 30 provided in this embodiment of this application includes the optical amplifier 10, which can amplify an optical signal, and further improve fidelity of the optical signal. A divergence angle of the emergent light of the optical amplifier 10 is small, so that optical power density of the emergent light can be improved, thereby facilitating detection of a signal-to-noise ratio of the optical signal.

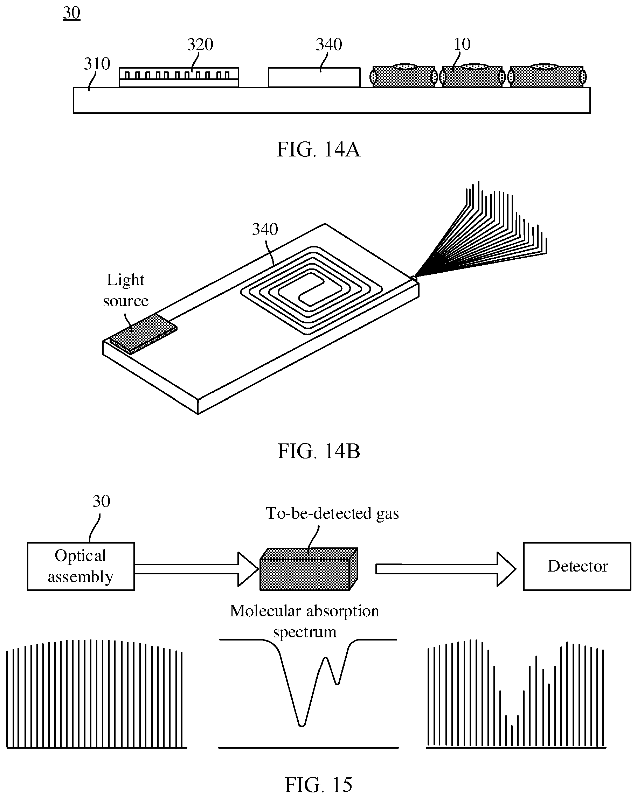

In some other embodiments, as shown in FIG. 14A, the optical assembly 30 may further include a microring 340. The microring 340 is disposed on the substrate 310, and is located between the laser 320 and the optical amplifier 10.

In this way, the optical assembly 30 may be configured to amplify a signal of an on-chip optical frequency comb. As shown in FIG. 14B, the laser 320 is used as a light source to provide an optical signal. The optical signal is transmitted to the microring 340. When the optical signal passes through the microring 340, a part of optical solitons are generated, presenting comb-like spectral distribution. Then, the optical amplifier 10 amplifies the output optical signal. In addition, the optical assembly may further extract some specific wavelengths of the optical frequency comb, and amplify the wavelengths through the optical amplifier 10.

For example, as shown in FIG. 15, the optical assembly 30 integrated with the on-chip optical frequency comb may be further used for gas detection. At a transmitting end, the optical frequency comb is used as a light source, and a specific band of the light source is selected for output. After the light source passes through to-be-detected gas, the to-be-detected gas interacts with the light source, causing missing teeth of a frequency comb in a transmitted spectrum. This indicates that in the to-be-detected gas, there is gas or a substance that strongly interacts with the band at which the output light source is located. In this way, gas detection is implemented.

In some other embodiments, an embodiment of this application further provides a detection apparatus, including the optical amplifier 10 and a receiver. The receiver is configured to receive an optical signal output by the optical amplifier 10. The detection apparatus may be used in fields such as optical communication, scanning and imaging, and lidar. A specific form of the detection apparatus is not specially limited in embodiments of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An optical amplifier, comprising:
a waveguide, comprising a core region and a cladding region, wherein the cladding region is disposed at a periphery of the core region; and
a photonic crystal disposed in the cladding region, wherein
the waveguide further comprises a light entrance side, a first light exit side, and a second light exit side, the core region is located between the light entrance side and the first light exit side, and the photonic crystal is located between the second light exit side and the core region; and
the photonic crystal is configured to: receive incident light from the light entrance side, and output first emergent light and second emergent light, the first emergent light is emergent from the first light exit side, and the second emergent light is emergent from the second light exit side.

2. The optical amplifier according to claim 1, wherein the first emergent light is transmitted from the photonic crystal, and the second emergent light is reflected from the photonic crystal.

3. The optical amplifier according to claim 1 or 2, wherein the photonic crystal is located on a surface of the cladding region.

4. The optical amplifier according to any one of claims 1 to 3, wherein the photonic crystal is located on a side of the core region in a thickness direction of the waveguide.

5. The optical amplifier according to claim 4, wherein in a first direction, an edge of the photonic crystal does not extend beyond an edge of the core region, the first direction is perpendicular to a direction in which the waveguide extends, and the first direction is further perpendicular to the thickness direction of the waveguide.

6. The optical amplifier according to claim 5, wherein a size of the photonic crystal in the first direction is the same as a size of the core region in the first direction, the first direction is perpendicular to the direction in which the waveguide extends, and the first direction is further perpendicular to the thickness direction of the waveguide.

7. The optical amplifier according to any one of claims 1 to 6, wherein there is a spacing between the photonic crystal and the core region.

8. The optical amplifier according to any one of claims 1 to 7, wherein the optical amplifier further comprises a buffer layer, and the buffer layer is located between the core region and the cladding region.

9. The optical amplifier according to any one of claims 1 to 8, wherein the photonic crystal comprises a third light exit side, the second emergent light is emergent from the third light exit side, and the third light exit side comprises a plurality of circular light exit holes.

10. The optical amplifier according to any one of claims 1 to 9, wherein the waveguide comprises any one of a ridge waveguide, a rectangular waveguide, or a buried waveguide.

11. The optical amplifier according to any one of claims 1 to 10, wherein the waveguide comprises the ridge waveguide, the ridge waveguide comprises a plate part and a ridge part that is disposed on the plate part, the core region comprises a portion that is of the plate part and that is covered by the ridge part, the cladding region comprises the ridge part and a portion of the plate part excluding the core region, and the photonic crystal is disposed in the ridge part.

12. The optical amplifier according to any one of claims 1 to 11, wherein the photonic crystal comprises a two-dimensional photonic crystal or a three-dimensional photonic crystal.

13. An optical assembly, comprising the optical amplifier according to any one of claims 1 to 12 and a light source, wherein the light source provides an optical signal for the optical amplifier.

14. An optical module, comprising a receiving optical sub-assembly and a transmitting optical sub-assembly, wherein the receiving optical sub-assembly receives an optical signal transmitted by the sending optical sub-assembly;
the receiving optical sub-assembly comprises the optical assembly according to claim 13;
and/or
the sending optical sub-assembly comprises the optical assembly according to claim 13.

15. An optical communication network system, comprising at least two optical communication devices and an optical fiber, wherein the optical communication devices are connected through the optical fiber, and the optical communication device comprises the optical module according to claim 14.

16. The optical communication network system according to claim 15, wherein the optical communication network system comprises a passive optical network system, the at least two optical communication devices comprise an optical line terminal, an optical network unit, and an optical network terminal, and the optical network unit is connected to the optical line terminal and the optical network terminal.

17. A detection apparatus, comprising the optical amplifier according to any one of claims 1 to 12 and a receiver, wherein the receiver is configured to receive an optical signal output by the optical amplifier.
